(19)

Europäisches
Patentamt
European
Patent Office
Office européen
des brevets

(11) **EP 3 512 204 B1**

(12) **EUROPEAN PATENT SPECIFICATION**

(45) Date of publication and mention
of the grant of the patent:
**16.10.2024 Bulletin 2024/42**

(21) Application number: **18215938.4**

(22) Date of filing: **31.12.2018**

(51) International Patent Classification (IPC):
*H04N 21/00* (2011.01)      *H04N 21/414* (2011.01)
*H04N 21/426* (2011.01)      *H04N 21/43* (2011.01)
*H04N 21/434* (2011.01)      *H04N 21/439* (2011.01)
*H04N 21/81* (2011.01)

(52) Cooperative Patent Classification (CPC):
**H04N 21/41422; H04N 21/42615; H04N 21/4305;
H04N 21/434; H04N 21/4392; H04N 21/8106**

(54) **A METHOD OF OPERATING AUDIO SYSTEMS, CORRESPONDING CIRCUIT, SYSTEM AND COMPUTER PROGRAM PRODUCT**

VERFAHREN ZUM BETRIEB VON AUDIOSYSTEMEN, ENTSPRECHENDER SCHALTUNG, SYSTEM- UND COMPUTERPROGRAMM-PRODUKT

PROCÉDÉ DE FONCTIONNEMENT DE SYSTÈMES AUDIO, CIRCUIT, SYSTÈME ET PROGRAMME INFORMATIQUE CORRESPONDANTS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.01.2018 IT 201800000790**

(43) Date of publication of application:
**17.07.2019 Bulletin 2019/29**

(73) Proprietor: **STMicroelectronics S.r.l.**
**20864 Agrate Brianza (MB) (IT)**

(72) Inventor: **SILVERIO, Antonio**
**20090 Vimodrone (Milano) (IT)**

(74) Representative: **Buzzi, Notaro & Antonielli d'Oulx
S.p.A.
Corso Vittorio Emmanuele II, 6
10123 Torino (IT)**

(56) References cited:
**CN-A- 104 731 748      US-A- 5 761 537
US-A1- 2009 228 615      US-A1- 2016 232 938**

EP 3 512 204 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Processed by Luminess, 75001 PARIS (FR)

**Description**

Technical field

The description relates to audio systems.

One or more embodiments may be applied to multichannel audio systems, e.g. for sound systems mounted on board of vehicles such as motor cars.

Technological background

Various audio applications may involve interfacing equipment capable of providing multiple audio streams (e.g. multichannel audio) with a device designed to receive these audio streams by using a single TDM serial audio interface.

Such an application may involve transporting signals from an arbitrary number of audio sources over a serial port in the presence of respective, different clock signals.

A desirable feature in this context is being able to derive these clock signals from sources such as PLL/Crystal generators without compromising accuracy of operation.

Document US 2016/0232938 A1 discloses a method for transmitting and/or receiving a potential aggressor audio signal. The method includes a transmission and/or a reception of successive groups of data timed by a first clock signal within respective successive frames synchronized by a second clock signal. In the presence of a risk of interference of the potential aggressor audio signal with a different, potential victim, signal, during the transmission or reception of the potential aggressor audio signal, the frequency of the first clock signal is modified while keeping the frequency of the second clock signal unchanged.

Document US 2009/0228615 A1 discloses a vehicle computer system having an audio entertainment system implemented in a logic unit and audio digital signal processor (DSP) independent from the host CPU. The audio entertainment system employs a set of ping/pong buffers and direct memory access (DMA) circuits to transfer data between different audio devices. Audio data is exchanged using a mapping overlay technique, in which the DMA circuits for two audio devices read and write to the same memory buffer.

Object and summary

Despite the extensive activity in the area, further improved solutions are desirable capable of providing such a feature.

An object of one or more embodiments is to contribute in providing such an improved solution.

According to one or more embodiments, such an object can be achieved by means of a method having the features set forth in the claims that follow.

One or more embodiments may relate to a corresponding circuit (e.g. an integrated circuit for use in implementing the method according to embodiments).

One or more embodiments may relate to a corresponding system (e.g. a sound system installed on board a motor vehicle).

One or more embodiments may relate to a corresponding computer program product loadable in the memory of at least one processing circuit (e.g., a MCU/CPU) and comprising software code portions for executing the acts of the method when the product is run on at least one processing circuit. As used herein, reference to such a computer program product is understood as being equivalent to reference to a computer-readable medium containing instructions for controlling the processing system in order to coordinate implementation of the method according to one or more embodiments. Reference to "at least one" processing circuit is intended to highlight the possibility for one or more embodiments to be implemented in modular and/or distributed form.

The claims are an integral part of the technical teaching provided herein in respect of the embodiments.

One or more embodiments facilitate transporting signals from an arbitrary number of audio sources over a serial port in the presence of respective, different clock signals.

One or more embodiments make it possible to adopt a same approach when the serial interface acts as a slave interface (receiving clock from outside).

One or more embodiments can be implemented via software, requiring few MIPS (million instructions per second) with the capability of being implemented in an inexpensive CPU such as a micro computer unit (MCU).

One or more embodiments can use the direct memory access (DMA) end of transfer time (EOT) to evaluate relative speed and buffer positions between the receiver (RX) and the transmitter (TX) flow.

In one or more embodiments, the DMA EOT can be increased, by increasing the buffering in the RX and TX flow; a resulting EOT rate, with an acceptable audio latency, can be in the order of the milliseconds, which is compatible with running a tuning algorithm on a low-end MPU/CPU.

One or more embodiments make it possible to change the TDM slots number at the serial interface towards an external DSP and/or power amplifier without affecting the stream engine.

One or more embodiments may avoid using different PLL's for the serial interface and the audio subsystem, facilitating long-term audio flow with no buffer underrun/overrun.

Brief description of the figures

One or more embodiments will now be described, by way of example only, with reference to the annexed figures, wherein:

- Figure 1 is exemplary of a possible context of use of embodiments;
- Figure 2 is exemplary of generating two clocks signals from a single PLL source;
- Figure 3 is exemplary of a principle of operation underlying embodiments; and
- Figure 4 is a functional diagram exemplary of operation of embodiments.

Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

Various audio applications may involve using a single TDM (time domain multiplex) serial audio interface 10 in order to interface equipment capable of providing multiple audio streams (e.g. multichannel audio) with a device designed to receive these audio streams.

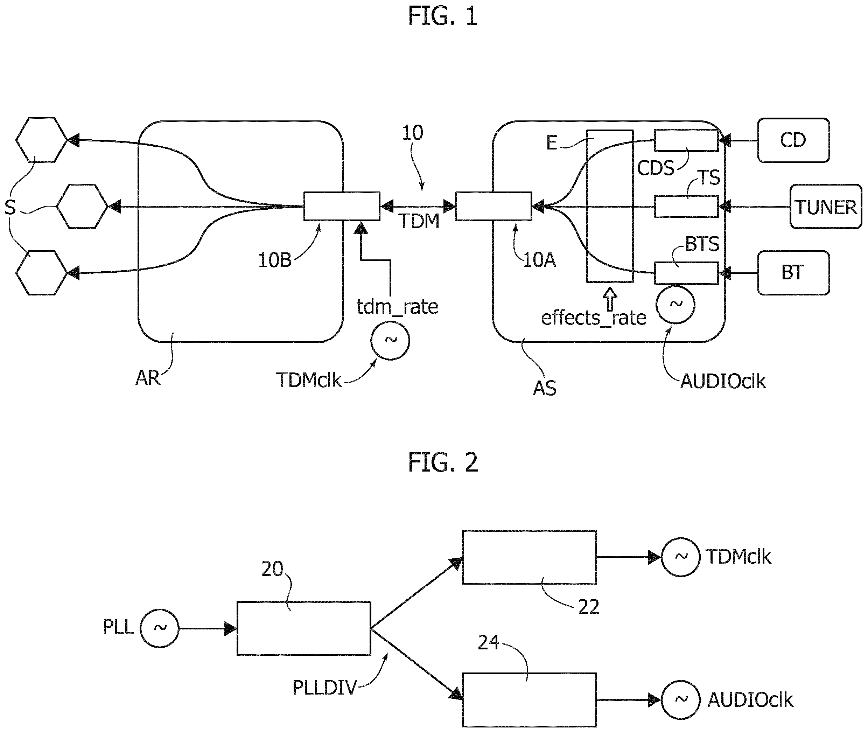

As exemplified in Figure 1, equipment capable of providing multiple audio streams can comprise an "audio source" AS comprising, e.g.:

- a CD player providing a sound signal comprising CD samples, e.g. CDS,
- a tuner T providing a sound signal comprising tuner samples, e.g. TS,
- a Bluetooth sound source BT providing a sound signal comprising Bluetooth samples, e.g. BTS.

Of course, this list of possible sound sources is merely exemplary. The audio source AS may in fact comprise any number and types of sound signal sources.

Also, an audio source AS as exemplified herein may comprise "effect" circuitry E (of a type known per se) in order to apply effects to the sound signals e.g. CDS, TS, BTS.

Many such effects are currently used in the audio sector. A surround effect e.g. involving feeding a left/right difference signal to the rear speakers in a car audio system is a simple example of such an effect.

Whatever the specific details of implementation of the audio source AS, for the purposes herein it may be assumed that operation thereof is clocked by an input clock signal AUDIOclk. This may also apply, e.g. to clocking the operation of the effect circuitry E by an effects_rate clock signal derived from AUDIOclk.

As exemplified in Figure 1, the device designed to receive the audio streams CDS, TS, BTS from the audio source AS via a (single) TDM serial audio interface 10 can be and "audio receiver" AR comprising an (e.g. multichannel) amplifier, comprising a DAC for converting to analog the digital audio streams from the source AS and driving a set of speakers S (e.g. front, rear, and so on).

Again, whatever the specific details of implementation of the audio receiver AR, for the purposes herein it may be assumed that the audio samples CDS, TS, BTS (with possible effects applied thereto at E) are transported from the audio source to the audio receiver AR (which may be a distinct device from the source AS) by means of an audio serial interface 10 in a TDM configuration operated with a TDM output clock signal TDMclk.

Due to the synchronous nature of the audio signals, a serial clock capable of adequately transporting the signals from the audio source AS (received at an input end 10A of the interface 10) to the audio receiver AR (coupled to the output end 10B of interface 10) is desirable, without having to implement complex and expensive sample rate conversion (SRC) and without adversely affecting the sound signals (e.g. avoiding underrun/overrun at the boundary between the two clock domains AUDIOclk and TDMclk).

In that respect one may also note that an effects block as E, if present, may be clocked to work "over" samples at a clock rate e.g. effects _rate.

A way to avoid underrun/overrun at the boundary between the two clock domains (assuming the TDM serial clock TDMclk has a rate tdm_rate) may involve the following relationship:

$$tdm\_rate = sample\_size*effects\_rate*number\_of\_channels$$

where number _of_channels is the number of audio channels involved (e.g., the number of speakers S).

For that purpose, one may consider the possibility using a single clock generator (e.g. a phase-locked loop - or PLL generator) for clocking both the audio source AS (at the "input" rate AUDIOclk) and the TDM serial interface 10 (at the "output" rate TDMclk).

This may occur according to the general layout exemplified in Figure 2, that is with a (high frequency) clock signal from a PLL generator fed (in manner known per se) to a clock frequency divider chain comprising a first common divider stage 20 applying a first divider value DIV to obtain a (first) frequency divided signal PLLDIV followed by two further divider stages 22 and 24 applying to PLLDIV respective divider values TDMdiv and AUDIOdiv to generate TDMclk and AUDIOclk.

A way of avoiding jitter and underrun/overrun issues may involve applying certain constraints on the values DIV, TDMdiv, AUDIOdiv applied in PLL divider chain 20, 22, 24, namely:

TDMclk = SMPLsize x Nch x AUDIOclk → PLL/ (DIVxTDMdiv) = SMPLsize x Nch x PLL/ (DIVxAUDIOdiv) → AUDIOdiv/TDMdiv = SMPLsize x Nch where SMPLsize denotes the size of the samples CDS, TS, BTS (e.g. 16 bit or 24 bit). For the sake of simplicity this may be assumed to be the same for the CDS, TS, BTS, which however is not a mandatory requirement.

In that respect it will also be noted that "effects rate" (and "tdm rate" as well) can be regarded just as particular values for AUDIOclk (and TDMclk), so that the expressions given above for tdm_rate and TDMclk apply.

If the ratio AUDIOdiv/TDMdiv is not an integer, the fractional, non-integer part will result in an offset between the TDM and AUDIO rates, in turn leading to an underrun/overrun.

A possible option might involve setting TDMdiv and obtaining therefrom AUDIOdiv = SMPLsize x Nch x TDMdiv in such a way to avoid any non-integer ratio problem.

In various audio applications AUDIOdiv admits (only) a limited set of values since audio sampling rates are standard (e.g. 96 kHz, 48 kHz, 44.1 kHz, and so on).

The resulting value for AUDIOdiv thus obtained may be unsuited to be applied in a PLL divide logic as exemplified in Figure 2.

At least notionally, that issue may be addressed in various ways.

A first approach may involve increasing the complexity of the clock generator of the audio source AS, so that AUDIOclk can be set to any arbitrary value as desired.

Another approach may involve using two PLLs and implementing sample rate conversion to adapt the "source" clock to the "sink" serial clock.

Sample rate conversion may be complex to implement as an hardware device, thus taking silicon space (e.g. at the SoC level). A software implementation can be CPU consuming, and may also undesirably affect the overall audio quality.

One or more embodiments may overcome these drawbacks by resorting to a buffering mechanism between the two clock domains (e.g. AUDIOclk and TDMclk) and a state machine, which may be implemented as a software component.

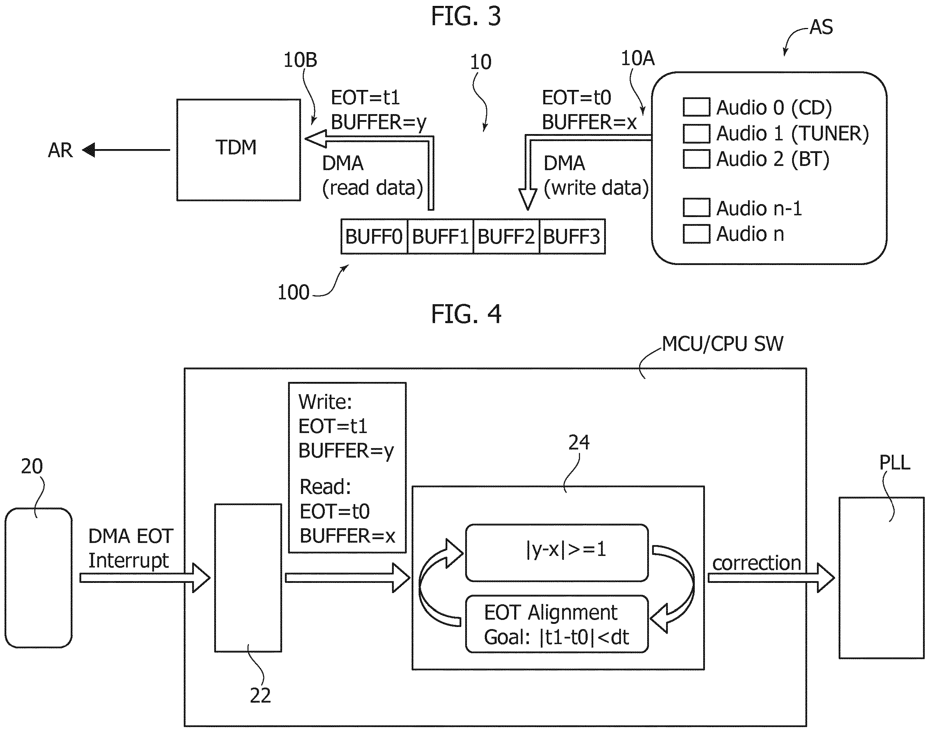

As exemplified in Figure 3, in one or more embodiments, buffers 100 (e.g. BUFF0, BUFF1, BUFF2, BUFF3, ...) are written by one clock domain (e.g. AUDIOclk) and read by the other (e.g. TDMclk), with the data written and read in a DMA (direct memory access) act.

An advantage of such an approach may lie in that DMA can be run when samples are actually ready (in write acts: see DMA-write data in Figure 3) and when they are actually required (in read acts: see DMA-read data in Figure 3).

The DMA EOT (end of transfer) time is a function of (e.g. proportional to) the rate of the data source (in write acts) and the rate of the data sink (in read acts).

For instance, the DMA function will write data to the buffer at the AUDIOclk rate, and read data from the buffer at the TDMclk rate.

As exemplified in Figure 4, the software (MCU/CPU SW) running the system (e.g. at SoC level) monitors completion of the buffer read and write acts (DMA EOT) e.g. under the control of a DMA controller 20 providing DAM/EOT interrupts to a DMA driver 22.

This will comprise the capability of identifying a buffer ID that is currently written (e.g. BUFFER = y with EOT = t1) and a buffer ID that is read (e.g. BUFFER = x with EOT = t0).

A state machine 24 may be provided configured to align the read/write buffer IDs with at least one buffer of distance (that is, $|y-x| \geq 1$): in that way concurrent read/write acts on the same memory location can be avoided.

Also, EOT time are monitored with the state machine 24 configured to compensate PLL jitter and drift (e.g. via a "correction" signal sent to the PLL circuit) so that EOT time difference is less than a certain threshold dt (that is, $|t1-t0| < dt$).

For instance the correction signal may act on the PLL e.g. by changing the fractional part of the PLL divider (that is DIV in block 20 in Figure 2) producing the signal PLLDIV, thus causing a corresponding clock in the blocks shown (which can be either TDMclk or AUDIOclk: see again Figure 2) to run slower/faster, so that the buffers 100 and the respective delays can be adjusted to match an expected goal.

One or more embodiments are applicable to an interface point in an otherwise conventional serial audio port (e.g. MSP), within the framework of a single, low power, MPU/CPU circuit, with the capability of running different TDM schemes.

A method according to one or more embodiments may comprise:

- receiving plural input audio signal streams (e.g. CDS, TS, BTS, E) from an audio source (e.g. AS) clocked at an input clock frequency (e.g. AUDIOclk) and producing therefrom a time domain multiplex, TDM, serial output stream clocked at a TDM output clock frequency (e.g. TDMclk),
- obtaining the input clock frequency and the TDM output clock frequency from clock frequency division (e.g. DIV, TDMdiv, AUDIOdiv; 20, 22, 24) of a master clock frequency (e.g. PLL),
- providing a set of memory buffers (e.g. 100; BUFF0, BUFF1, BUFF2, BUFF3), and
- writing audio signal samples from said input audio signal streams into buffers in the set of memory buffers with said writing clocked at the input clock frequency, and
- producing said TDM serial output stream from audio signal samples buffered in said set of memory buffers by reading the buffered audio signal samples with said reading clocked at said TDM output clock frequency.

One or more embodiments may comprise writing resp. reading audio signal samples into resp. from buffers in the set of memory buffers during direct memory access, DMA, to said buffers.

One or more embodiments may comprise selecting (e.g. 24) non-coincident memory buffers in the set of memory buffers for concurrently writing (see e.g. y in Figures 3 and 4) resp. reading (see e.g. x in Figures 3 and 4) audio signal samples into resp. from buffers in the set of memory buffers, wherein concurrent read/write acts on a same memory location are avoided.

One or more embodiments may comprise:

- monitoring end of transfer, EOT, times (see e.g. t1, t0 in Figures 3 and 4) of said writing resp. reading audio signal samples into resp. from buffers in the set of memory buffers,
- controlling (e.g. 24, correction) the clock frequency division of said master clock frequency by maintaining within a certain range the difference between the end of transfer times of writing resp. reading audio signal samples into resp. from buffers in the set of memory buffers.

One or more embodiments may comprise obtaining (see e.g. Figure 2) the TDM output clock frequency and the input clock frequency from:

- a clock frequency division act (e.g. 20) by a clock frequency divider value (e.g. DIV) providing a frequency divided clock signal (e.g. PLLDIV),
- first (e.g. 22) and second (e.g. 24) further clock frequency division acts by first (e.g. TDMdiv) and second (e.g. AUDIOdiv) further clock frequency divider values applied to the frequency divided clock signal to produce the TDM output clock frequency and the input clock frequency, respectively.

One or more embodiments may comprise controlling the clock frequency division of said master clock frequency by controlling the clock frequency divider value in said clock frequency division act providing said frequency divided clock signal.

In one or more embodiments, a circuit (e.g. 10) may comprise:

- an input end (see e.g. 10A in Figure 3) configured to receive plural input audio signal streams from an audio source clocked at an input clock frequency,

- an output end (see e.g. 10B in Figure 3) configured to produce, from the audio signal streams received at the input end, a time domain multiplex, TDM, serial output stream clocked at a TDM output clock frequency,
- a set of memory buffers in a signal path from the input end (10A) to the output end (10B), the memory buffers controllable (e.g. via MCU/CPU SW) to implement the method of one or more embodiments by:

- writing audio signal samples from said input audio signal streams into buffers in the set of memory buffers with said writing clocked at the input clock frequency, and
- producing said TDM serial output stream from audio signal samples buffered in said set of memory buffers by reading the buffered audio signal samples with said reading clocked at said TDM output clock frequency.

One or more embodiments may comprise a clock generator (see e.g. 20, 22, 24 in Figure 2) configured to produce the input clock frequency and the TDM output clock frequency by clock frequency division of a master clock frequency.

In one or more embodiments an audio system may comprise:

- a circuit according to one or more embodiments,
- an audio source (e.g. AS) clocked at said input clock frequency to provide plural input audio signal streams to the input end of the circuit, and
- an audio receiver (e.g. AR) configured to receive said time domain multiplex, TDM, serial output stream clocked at a TDM output clock frequency from the output end of the circuit.

One or more embodiments may comprise a computer program product (see e.g. MCU/CPU SW in Figure 4) loadable in the memory of at least one processing circuit (e.g. a MCU/CPU) and comprising software code portions for executing the acts of the method of one or more embodiments as a result of the product being run on at least one processing circuit.

Without prejudice to the underlying principles, the details and embodiments may vary, even significantly, with respect to what has been described by way of example only, without departing from the extent of protection.

The extent of protection is defined by the annexed claims.

## Claims

1. A method, comprising:

    - receiving plural input audio signal streams (CDS, TS, BTS, E) from an audio source (AS) clocked at an input clock frequency (AUDIOclk) and producing therefrom a time domain multiplex, TDM, serial output stream clocked at a TDM output clock frequency (TDMclk),
    - obtaining the input clock frequency (AUDIOclk) and the TDM output clock frequency (TDMclk) from clock frequency division (DIV, TDMdiv, AUDIOdiv; 20, 22, 24) of a master clock frequency (PLL),
    - providing a set of memory buffers (100; BUFF0, BUFF1, BUFF2, BUFF3),
    - writing audio signal samples from said input audio signal streams into buffers in the set of memory buffers (100; BUFF0, BUFF1, BUFF2, BUFF3) with said writing clocked at the input clock frequency (AUDIOclk),
    - producing said TDM serial output stream from audio signal samples buffered in said set of memory buffers (100; BUFF0, BUFF1, BUFF2, BUFF3) by reading the buffered audio signal samples with said reading clocked at said TDM output clock frequency (TDMclk),
    - providing a state machine (24) configured to monitor end of transfer, EOT, times (t1, t0) of said writing audio signal samples into buffers in the set of memory buffers (100; BUFF0, BUFF1, BUFF2, BUFF3) and of said reading audio signal samples from buffers in the set of memory buffers (100; BUFF0, BUFF1, BUFF2, BUFF3),
    - producing, at said state machine (24), a correction signal as a function of said monitored end of transfer times (t1, t0) and controlling the clock frequency division (DIV, TDMdiv, AUDIOdiv; 20, 22, 24) of said master clock frequency (PLL) via said correction signal by maintaining within a certain range the difference between the end of transfer times of writing audio signal samples into buffers in the set of memory buffers (100; BUFF0, BUFF1, BUFF2, BUFF3) and reading audio signal samples from buffers in the set of memory buffers (100; BUFF0, BUFF1, BUFF2, BUFF3).

2. The method of claim 1, comprising writing audio signal samples into buffers in the set of memory buffers (100; BUFF0, BUFF1, BUFF2, BUFF3) and reading audio signal samples from buffers in the set of memory buffers (100;

BUFF0, BUFF1, BUFF2, BUFF3) during direct memory access, DMA, to said buffers.

3. The method of claim 1 or claim 2, comprising selecting (24) non-coincident memory buffers in the set of memory buffers (100; BUFF0, BUFF1, BUFF2, BUFF3) for concurrently writing (y) audio signal samples into buffers in the set of memory buffers (100; BUFF0, BUFF1, BUFF2, BUFF3) and reading (x) audio signal samples from buffers in the set of memory buffers (100; BUFF0, BUFF1, BUFF2, BUFF3).

4. The method of any of the previous claims, comprising obtaining the TDM output clock frequency (TDMclk) and the input clock frequency (AUDIOclk) from:

- a clock frequency division act (20) by a clock frequency divider value (DIV) providing a frequency divided clock signal (PLLDIV),
- first (22) and second (24) further clock frequency division acts by first (TDMdiv) and second (AUDIOdiv) further clock frequency divider values applied to the frequency divided clock signal (PLLDIV) to produce the TDM output clock frequency (TDMclk) and the input clock frequency (AUDIOclk), respectively.

5. The method of claim 4, comprising controlling the clock frequency division (20, 22, 24) of said master clock frequency (PLL) by controlling the clock frequency divider value (DIV) in said clock frequency division act (20) providing said frequency divided clock signal (PLLDIV).

6. A circuit (10), comprising:

- an input end (10A) configured to receive plural input audio signal streams (CDS, TS, BTS, E) from an audio source (AS) clocked at an input clock frequency (AUDIOclk),
- an output end (10B) configured to produce, from the audio signal streams received at the input end (10A), a time domain multiplex, TDM, serial output stream clocked at a TDM output clock frequency (TDMclk),
- a set of memory buffers (100; BUFF0, BUFF1, BUFF2, BUFF3) in a signal path from the input end (10A) to the output end (10B), the memory buffers (100; BUFF0, BUFF1, BUFF2, BUFF3) controllable (MCU/CPU SW) to implement the method of any of claims 1 to 5 by:

  - writing audio signal samples from said input audio signal streams into buffers in the set of memory buffers (100; BUFF0, BUFF1, BUFF2, BUFF3) with said writing clocked at the input clock frequency (AUDIOclk),
  - producing said TDM serial output stream from audio signal samples buffered in said set of memory buffers (100; BUFF0, BUFF1, BUFF2, BUFF3) by reading the buffered audio signal samples with said reading clocked at said TDM output clock frequency (TDMclk),
  - monitoring, at a state machine (24), end of transfer, EOT, times (t1, t0) of said writing audio signal samples into buffers in the set of memory buffers (100; BUFF0, BUFF1, BUFF2, BUFF3) and of said reading audio signal samples from buffers in the set of memory buffers (100; BUFF0, BUFF1, BUFF2, BUFF3),
  - producing, at said state machine (24), a correction signal as a function of said monitored end of transfer times (t1, t0),
  - controlling the clock frequency division (DIV, TDMdiv, AUDIOdiv; 20, 22, 24) of said master clock frequency (PLL) via said correction signal by maintaining within a certain range the difference between the end of transfer times of writing audio signal samples into buffers in the set of memory buffers (100; BUFF0, BUFF1, BUFF2, BUFF3) and reading audio signal samples from buffers in the set of memory buffers (100; BUFF0, BUFF1, BUFF2, BUFF3).

7. The circuit (10) of claim 6, comprising a clock generator (20, 22, 24) configured to produce the input clock frequency (AUDIOclk) and the TDM output clock frequency (TDMclk) by clock frequency division (DIV, TDMdiv, AUDIOdiv; 20, 22, 24) of a master clock frequency (PLL).

8. An audio system, comprising:

- a circuit (10) according to claim 6 or claim 7,
- an audio source (AS) clocked at said input clock frequency (AUDIOclk) to provide plural input audio signal streams (CDS, TS, BTS, E) to the input end (10A) of the circuit (10), and
- an audio receiver (AR) configured to receive said time domain multiplex, TDM, serial output stream clocked at a TDM output clock frequency (TDMclk) from the output end (10B) of the circuit (10).

9. A computer program product (MCU/CPU SW) loadable in the memory of at least one processing circuit and comprising software code portions for executing the acts of the method of any of claims 1 to 5 as a result of running the product on at least one processing circuit.

**Patentansprüche**

1. Verfahren, das Folgendes umfasst:

    - Empfangen mehrerer Eingangsaudiosignalströme (CDS, TS, BTS, E) von einer Audioquelle (AS), die mit einer Eingangstaktfrequenz (AUDIOclk) getaktet wird, und Erzeugen daraus eines seriellen Zeitbereichsmultiplex, TDM,-Ausgangsstrom, der mit einer TDM-Ausgangstaktfrequenz (TDMclk) getaktet wird,
    - Erhalten der Eingangstaktfrequenz (AUDIOclk) und der TDM-Ausgangstaktfrequenz (TDMclk) aus einer Taktfrequenzteilung (DIV, TDMdiv, AUDIOdiv; 20, 22, 24) einer Haupttaktfrequenz (PLL),
    - Bereitstellen eines Satzes von Speicherpuffern (100; BUFF0, BUFF1, BUFF2, BUFF3),
    - Schreiben von Audiosignalabtastwerten aus den Eingangsaudiosignalströmen in Puffer im Satz von Speicherpuffern (100; BUFF0, BUFF1, BUFF2, BUFF3), wobei das Schreiben mit der Eingangstaktfrequenz (AUDIOclk) getaktet wird,
    - Erzeugen des seriellen TDM-Ausgangsstroms aus Audiosignalabtastwerten, die im Satz von Speicherpuffern (100; BUFF0, BUFF1, BUFF2, BUFF3) gepuffert werden, indem die gepufferten Audiosignalabtastwerte gelesen werden, wobei das Lesen mit der TDM-Ausgangstaktfrequenz (TDMclk) getaktet wird,
    - Bereitstellen einer Zustandsmaschine (24), die dazu konfiguriert ist, das Ende der Übertragungszeiten, EOT-Zeiten, (t1, t0) des Schreibens von Audiosignalabtastwerten in Puffer im Satz von Speicherpuffern (100; BUFF0, BUFF1, BUFF2, BUFF3) und des Lesens von Audiosignalabtastwerten aus Puffern im Satz von Speicherpuffern (100; BUFF0, BUFF1, BUFF2, BUFF3) zu überwachen,
    - Erzeugen eines Korrektursignals in Abhängigkeit von dem überwachten Ende der Übertragungszeiten (t1, t0) an der Zustandsmaschine (24) und Steuern der Taktfrequenzteilung (DIV, TDMdiv, AUDIOdiv; 20, 22, 24) der Haupttaktfrequenz (PLL) über das Korrektursignal, indem die Differenz zwischen dem Ende der Übertragungszeiten des Schreibens von Audiosignalabtastwerten in Puffer im Satz von Speicherpuffern (100; BUFF0, BUFF1, BUFF2, BUFF3) und des Lesens von Audiosignalabtastwerten aus Puffern im Satz von Speicherpuffern (100; BUFF0, BUFF1, BUFF2, BUFF3) innerhalb eines bestimmten Bereichs gehalten wird.

2. Verfahren nach Anspruch 1, das das Schreiben von Audiosignalabtastwerten in Puffer im Satz von Speicherpuffern (100; BUFF0, BUFF1, BUFF2, BUFF3) und das Lesen von Audiosignalabtastwerten aus Puffern im Satz von Speicherpuffern (100; BUFF0, BUFF1, BUFF2, BUFF3) während des direkten Speicherzugriffs, DMA, auf die Puffer umfasst.

3. Verfahren nach Anspruch 1 oder Anspruch 2, das das Auswählen (24) nicht koinzidenter Speicherpuffer im Satz von Speicherpuffern (100; BUFF0, BUFF1, BUFF2, BUFF3) zum gleichzeitigen Schreiben (y) von Audiosignalabtastwerten in Puffer im Satz von Speicherpuffern (100; BUFF0, BUFF1, BUFF2, BUFF3) und Lesen (x) von Audiosignalabtastwerten aus Puffern im Satz von Speicherpuffern (100; BUFF0, BUFF1, BUFF2, BUFF3) umfasst.

4. Verfahren nach einem der vorherigen Ansprüche, das das Erhalten der TDM-Ausgangstaktfrequenz (TDMclk) und der Eingangstaktfrequenz (AUDIOclk) aus Folgendem umfasst:

    - einem Taktfrequenzteilungsschritt (20) durch einen Taktfrequenzteilerwert (DIV), der ein frequenzgeteiltes Taktsignal (PLLDIV) bereitstellt,
    - einem ersten (22) und einem zweiten (24) weiteren Taktfrequenzteilungsschritt durch erste (TDMdiv) und zweite (AUDIOdiv) weitere Taktfrequenzteilerwerte, die auf das frequenzgeteilte Taktsignal (PLLDIV) angewendet werden, um die TDM-Ausgangstaktfrequenz (TDMclk) bzw. die Eingangstaktfrequenz (AUDIOclk) zu erzeugen.

5. Verfahren nach Anspruch 4, das das Steuern der Taktfrequenzteilung (20, 22, 24) der Haupttaktfrequenz (PLL) durch das Steuern des Taktfrequenzteilerwerts (DIV) im Taktfrequenzteilungsschritt (20), der das frequenzgeteilte Taktsignal (PLLDIV) bereitstellt, umfasst.

6. Schaltung (10), die Folgendes umfasst:

- ein Eingangsende (10A), das dazu konfiguriert ist, mehrere Eingangsaudiosignalströme (CDS, TS, BTS, E) von einer Audioquelle (AS) zu empfangen, die mit einer Eingangstaktfrequenz (AUDIOclk) getaktet wird,
- ein Ausgangsende (10B), das dazu konfiguriert ist, einen seriellen Zeitbereichsmultiplex, TDM,-Ausgangsstrom, der mit einer TDM-Ausgangstaktfrequenz (TDMclk) getaktet wird, aus den am Eingangsende (10A) empfangenen Audiosignalströmen zu erzeugen,
- einen Satz von Speicherpuffern (100; BUFF0, BUFF1, BUFF2, BUFF3) in einem Signalpfad vom Eingangsende (10A) zum Ausgangsende (10B), wobei die Speicherpuffer (100; BUFF0, BUFF1, BUFF2, BUFF3) steuerbar (MCU/CPU SW) sind, um das Verfahren nach einem der Ansprüche 1 bis 5 durch Folgendes zu implementieren:
- Schreiben von Audiosignalabtastwerten aus den Eingangsaudiosignalströmen in Puffer im Satz von Speicherpuffern (100; BUFF0, BUFF1, BUFF2, BUFF3), wobei das Schreiben mit der Eingangstaktfrequenz (AUDIOclk) getaktet wird,
- Erzeugen des seriellen TDM-Ausgangsstroms aus Audiosignalabtastwerten, die im Satz von Speicherpuffern (100; BUFF0, BUFF1, BUFF2, BUFF3) gepuffert werden, indem die gepufferten Audiosignalabtastwerte gelesen werden, wobei das Lesen mit der TDM-Ausgangstaktfrequenz (TDMclk) getaktet wird,
- Überwachen, an einer Zustandsmaschine (24), eines Endes der Übertragungszeiten, EOT-Zeiten, (t1, t0) des Schreibens von Audiosignalabtastwerten in Puffer im Satz von Speicherpuffern (100; BUFF0, BUFF1, BUFF2, BUFF3) und des Lesens von Audiosignalabtastwerten aus Puffern im Satz von Speicherpuffern (100; BUFF0, BUFF1, BUFF2, BUFF3),
- Erzeugen, an der Zustandsmaschine (24), eines Korrektursignals in Abhängigkeit von dem überwachten Ende der Übertragungszeiten (t1, t0),
- Steuern der Taktfrequenzteilung (DIV, TDMdiv, AUDIOdiv; 20, 22, 24) der Haupttaktfrequenz (PLL) durch das Korrektursignal, indem die Differenz zwischen dem Ende der Übertragungszeiten des Schreibens von Audiosignalabtastwerten in Puffer im Satz von Speicherpuffern (100; BUFF0, BUFF1, BUFF2, BUFF3) und des Lesens von Audiosignalabtastwerten aus Puffern im Satz von Speicherpuffern (100; BUFF0, BUFF1, BUFF2, BUFF3) innerhalb eines bestimmten Bereichs gehalten wird.

7. Schaltung (10) nach Anspruch 6, die einen Taktgenerator (20, 22, 24) umfasst, der dazu konfiguriert ist, die Eingangstaktfrequenz (AUDIOclk) und die TDM-Ausgangstaktfrequenz (TDMclk) durch eine Taktfrequenzteilung (DIV, TDMdiv, AUDIOdiv; 20, 22, 24) einer Haupttaktfrequenz (PLL) zu erzeugen.

8. Audiosystem, das Folgendes umfasst:

- eine Schaltung (10) nach Anspruch 6 oder Anspruch 7,
- eine Audioquelle (AS), die mit der Eingangstaktfrequenz (AUDIOclk) getaktet wird, um mehrere Eingangsaudiosignalströme (CDS, TS, BTS, E) an das Eingangsende (10A) der Schaltung (10) bereitzustellen, und
- einen Audioempfänger (AR), der dazu konfiguriert ist, den seriellen Zeitbereichsmultiplex, TDM,-Ausgabestrom, der mit einer TDM-Ausgangstaktfrequenz (TDMclk) getaktet wird, vom Ausgangsende (10B) der Schaltung (10) zu empfangen.

9. Computerprogrammprodukt (MCU/CPU SW), das in den Speicher mindestens einer Verarbeitungsschaltung ladbar ist und Softwarecodeteile zum Ausführen der Schritte des Verfahrens nach einem der Ansprüche 1 bis 5 als Ergebnis des Betriebs des Produkts auf mindestens einer Verarbeitungsschaltung umfasst.


**Revendications**

1. Procédé, comprenant :

- la réception de plusieurs flux de signal audio d'entrée (CDS, TS, BTS, E) provenant d'une source audio (AS) cadencée à une fréquence d'horloge d'entrée (AUDIOclk) et la production à partir de ceux-ci d'un flux de sortie série à multiplexage temporel, TDM, cadencé à une fréquence d'horloge de sortie TDM (TDMclk),
- l'obtention de la fréquence d'horloge d'entrée (AUDIOclk) et de la fréquence d'horloge de sortie TDM (TDMclk) par division de fréquence d'horloge (DIV, TDMdiv, AUDIOdiv ; 20, 22, 24) d'une fréquence d'horloge maîtresse (PLL),
- la mise à disposition d'un ensemble de tampons de mémoire (100 ; BUFF0, BUFF1, BUFF2, BUFF3),
- l'écriture d'échantillons de signal audio tirés desdits flux de signal audio d'entrée dans des tampons de l'ensemble de tampons de mémoire (100 ; BUFF0, BUFF1, BUFF2, BUFF3), ladite écriture étant cadencée à la fréquence d'horloge d'entrée (AUDIOclk),

- la production dudit flux de sortie série TDM à partir d'échantillons de signal audio mis en tampon dans ledit ensemble de tampons de mémoire (100 ; BUFF0, BUFF1, BUFF2, BUFF3) par lecture des échantillons de signal audio mis en tampon, ladite lecture étant cadencée à ladite fréquence d'horloge de sortie TDM (TDMclk),
- la mise à disposition d'un automate fini (24) configuré pour surveiller des instants de fin de transfert, EOT, (t1, t0) de ladite écriture d'échantillons de signal audio dans des tampons de l'ensemble de tampons de mémoire (100 ; BUFF0, BUFF1, BUFF2, BUFF3) et de ladite lecture d'échantillons de signal audio dans des tampons de l'ensemble de tampons de mémoire (100 ; BUFF0, BUFF1, BUFF2, BUFF3),
- la production, au niveau dudit automate fini (24), d'un signal de correction en fonction desdits instants de fin de transfert surveillés (t1, t0) et la commande de la division de fréquence d'horloge (DIV, TDMdiv, AUDIOdiv ; 20, 22, 24) de ladite fréquence d'horloge maîtresse (PLL) par l'intermédiaire dudit signal de correction par maintien à l'intérieur d'une certaine plage de la différence entre les instants de fin de transfert de l'écriture d'échantillons de signal audio dans des tampons de l'ensemble de tampons de mémoire (100 ; BUFF0, BUFF1, BUFF2, BUFF3) et de la lecture d'échantillons de signal audio dans des tampons de l'ensemble de tampons de mémoire (100 ; BUFF0, BUFF1, BUFF2, BUFF3).

2. Procédé selon la revendication 1, comprenant l'écriture d'échantillons de signal audio dans des tampons de l'ensemble de tampons de mémoire (100 ; BUFF0, BUFF1, BUFF2, BUFF3) et la lecture d'échantillons de signal audio dans des tampons de l'ensemble de tampons de mémoire (100 ; BUFF0, BUFF1, BUFF2, BUFF3) durant un accès direct en mémoire, DMA, auxdits tampons.

3. Procédé selon la revendication 1 ou la revendication 2, comprenant la sélection (24) de tampons de mémoire non coïncidents de l'ensemble de tampons de mémoire (100 ; BUFF0, BUFF1, BUFF2, BUFF3) pour simultanément l'écriture (y) d'échantillons de signal audio dans des tampons de l'ensemble de tampons de mémoire (100 ; BUFF0, BUFF1, BUFF2, BUFF3) et la lecture (x) d'échantillons de signal audio dans des tampons de l'ensemble de tampons de mémoire (100 ; BUFF0, BUFF1, BUFF2, BUFF3).

4. Procédé selon n'importe laquelle des revendications précédentes, comprenant l'obtention de la fréquence d'horloge de sortie TDM (TDMclk) et de la fréquence d'horloge d'entrée (AUDIOclk) par :

- une action de division de fréquence d'horloge (20) par une valeur de diviseur de fréquence d'horloge (DIV) fournissant un signal d'horloge à fréquence divisée (PLLDIV),
- des première (22) et deuxième (24) actions de division de fréquence d'horloge supplémentaires par des première (TDMdiv) et deuxième (AUDIOdiv) valeurs de diviseur de fréquence d'horloge supplémentaires appliquées au signal d'horloge à fréquence divisée (PLLDIV) pour produire la fréquence d'horloge de sortie TDM (TDMclk) et la fréquence d'horloge d'entrée (AUDIOclk), respectivement.

5. Procédé selon la revendication 4, comprenant la commande de la division de fréquence d'horloge (20, 22, 24) de ladite fréquence d'horloge maîtresse (PLL) par commande de la valeur de diviseur de fréquence d'horloge (DIV) dans ladite action de division de fréquence d'horloge (20) fournissant ledit signal d'horloge à fréquence divisée (PLLDIV).

6. Circuit (10), comprenant :

- une borne d'entrée (10A) configurée pour recevoir plusieurs flux de signal audio d'entrée (CDS, TS, BTS, E) provenant d'une source audio (AS) cadencée à une fréquence d'horloge d'entrée (AUDIOclk),
- une borne de sortie (10B) configurée pour produire, à partir des flux de signal audio reçus à la borne d'entrée (10A), un flux de sortie série à multiplexage temporel, TDM, cadencé à une fréquence d'horloge de sortie TDM (TDMclk),
- un ensemble de tampons de mémoire (100 ; BUFF0, BUFF1, BUFF2, BUFF3) dans un chemin de signal allant de la borne d'entrée (10A) à la borne de sortie (10B), les tampons de mémoire (100 ; BUFF0, BUFF1, BUFF2, BUFF3) étant commandables (MCU/CPU SW) pour mettre en oeuvre le procédé selon n'importe laquelle des revendications 1 à 5 par :

- écriture d'échantillons de signal audio tirés desdits flux de signal audio d'entrée dans des tampons de l'ensemble de tampons de mémoire (100 ; BUFF0, BUFF1, BUFF2, BUFF3), ladite écriture étant cadencée à la fréquence d'horloge d'entrée (AUDIOclk),
- production dudit flux de sortie série TDM à partir d'échantillons de signal audio mis en tampon dans ledit ensemble de tampons de mémoire (100 ; BUFF0, BUFF1, BUFF2, BUFF3) par lecture des échantillons de signal audio mis en tampon, ladite lecture étant cadencée à ladite fréquence d'horloge de sortie TDM (TDMclk),

- surveillance, au niveau d'un automate fini (24), d'instants de fin de transfert, EOT, (t1, t0) de ladite écriture d'échantillons de signal audio dans des tampons de l'ensemble de tampons de mémoire (100 ; BUFF0, BUFF1, BUFF2, BUFF3) et de ladite lecture d'échantillons de signal audio dans des tampons de l'ensemble de tampons de mémoire (100 ; BUFF0, BUFF1, BUFF2, BUFF3),

- production, au niveau dudit automate fini (24), d'un signal de correction en fonction desdits instants de fin de transfert surveillés (t1, t0),

- commande de la division de fréquence d'horloge (DIV, TDMdiv, AUDIOdiv ; 20, 22, 24) de ladite fréquence d'horloge maîtresse (PLL) par l'intermédiaire dudit signal de correction par maintien à l'intérieur d'une certaine plage de la différence entre les instants de fin de transfert de l'écriture d'échantillons de signal audio dans des tampons de l'ensemble de tampons de mémoire (100 ; BUFF0, BUFF1, BUFF2, BUFF3) et de la lecture d'échantillons de signal audio dans des tampons de l'ensemble de tampons de mémoire (100 ; BUFF0, BUFF1, BUFF2, BUFF3).

7. Circuit (10) selon la revendication 6, comprenant un générateur d'horloge (20, 22, 24) configuré pour produire la fréquence d'horloge d'entrée (AUDIOclk) et la fréquence d'horloge de sortie TDM (TDMclk) par division de fréquence d'horloge (DIV, TDMdiv, AUDIOdiv ; 20, 22, 24) d'une fréquence d'horloge maîtresse (PLL).

8. Système audio, comprenant :

- un circuit (10) selon la revendication 6 ou la revendication 7,
- une source audio (AS) cadencée à ladite fréquence d'horloge d'entrée (AUDIOclk) pour fournir plusieurs flux de signal audio d'entrée (CDS, TS, BTS, E) à la borne d'entrée (10A) du circuit (10), et
- un récepteur audio (AR) configuré pour recevoir ledit flux de sortie série à multiplexage temporel, TDM, cadencé à une fréquence d'horloge de sortie TDM (TDMclk) provenant de la borne de sortie (10B) du circuit (10).

9. Produit-programme d'ordinateur (MCU/CPU SW) chargeable dans la mémoire d'au moins un circuit de traitement et comprenant des portions de code logiciel servant à exécuter les actions du procédé selon n'importe laquelle des revendications 1 à 5 lorsqu'on fait tourner le produit sur au moins un circuit de traitement.

FIG. 1

FIG. 2

EP 3 512 204 B1

FIG. 3

FIG. 4

**EP 3 512 204 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160232938 A1
- US 20090228615 A1